# FASCICULE DE BREVET EUROPEEN

(11) **EP 4 085 478 B1**
(45) Date de publication et mention de la délivrance du brevet: **25.10.2023**
(21) Numéro de dépôt: 20845581.6
(22) Date de dépôt: 15.12.2020
(51) Int. Cl.: H01L 21/18, H01L 21/02, H01L 21/324, H01L 29/16

(54) **PROCEDE DE FABRICATION D'UNE STRUCTURE COMPOSITE COMPRENANT UNE COUCHE MINCE MONOCRISTALLINE SUR UN SUBSTRAT SUPPORT**
VERFAHREN ZUR HERSTELLUNG EINER VERBUNDSTRUKTUR MIT EINER DÜNNEN MONOKRISTALLINEN SCHICHT AUF EINEM TRÄGERSUBSTRAT
METHOD FOR PRODUCING A COMPOSITE STRUCTURE COMPRISING A THIN MONOCRISTALLINE LAYER ON A CARRIER SUBSTRATE

(30) Priorité: 30.12.2019 FR 1915720
(43) Date de publication de la demande: 09.11.2022
(73) Titulaire: SOITEC, 38190 Bernin (FR)
(72) Inventeur: GAUDIN, Gweltaz, 38920 Crolles (FR)
(74) Mandataire: IP Trust
(86) Numéro de dépôt international: PCT/FR2020/052451
(87) Numéro de publication internationale: WO 2021/136894

(56) Documents cités:
- US-A1- 2002 123 204
- US-A1- 2004 151 917
- US-A1- 2018 323 069

## Description

### DOMAINE DE L'INVENTION

La présente invention concerne le domaine des matériaux semiconducteurs pour composants microélectroniques. Elle concerne en particulier un procédé de fabrication d'une structure composite comprenant une couche mince monocristalline, par exemple en carbure de silicium, disposée sur un substrat support, et autorisant un alignement précis sur un axe cristallographique de ladite couche mince.

### ARRIERE PLAN TECHNOLOGIQUE DE L'INVENTION

L'intérêt pour le carbure de silicium (SiC) a considérablement augmenté au cours des dernières années, car ce matériau semiconducteur peut accroître la capacité de traitement de l'énergie. Le SiC est de plus en plus largement utilisé pour la fabrication de dispositifs de puissance innovants, pour répondre aux besoins de domaines montants de l'électronique, comme notamment les véhicules électriques.

Les dispositifs de puissance et les systèmes intégrés d'alimentation basés sur du carbure de silicium monocristallin peuvent gérer une densité de puissance beaucoup plus élevée par rapport à leurs homologues traditionnels en silicium, et ce avec des dimensions de zone active inférieures. Pour limiter encore les dimensions des dispositifs de puissance sur SiC, il est avantageux de fabriquer des composants verticaux plutôt que latéraux. Pour cela, une conduction électrique verticale, entre une électrode disposée en face avant de la structure SiC et une électrode disposée en face arrière, doit être autorisée par ladite structure.

Les substrats en SiC monocristallin de haute qualité destinés à l'industrie microélectronique restent néanmoins chers et difficiles à approvisionner en grande taille. Il est donc avantageux de recourir à des solutions de transfert de couches minces, pour élaborer des structures composites comprenant typiquement une couche mince en SiC monocristallin sur un substrat support plus bas coût, qu'il soit monocristallin ou poly-cristallin. Une solution de transfert de couche mince bien connu est le procédé Smart Cut^{™}, basé sur une implantation d'ions légers et sur un assemblage par collage direct. Un tel procédé permet par exemple de fabriquer une structure composite comprenant une couche mince en SiC monocristallin (c-SiC), prélevée d'un substrat donneur en c-SiC à faible densité de défauts, assemblée en contact direct ou via une couche métallique avec un substrat support en SiC poly-cristallin (p-SiC) ou en SiC monocristallin. Une telle structure composite autorise une conduction électrique verticale.

Certains composants électroniques verticaux fabriqués sur une structure composite telle qu'énoncée nécessitent un alignement précis par rapport aux axes cristallographiques de la couche mince en c-SiC, pour atteindre un haut niveau de performance. La précision requise est typiquement de +/-0,1°. En pratique, il faut pouvoir aligner un élément du composant électronique (par exemple, la grille selon sa longueur) avec l'axe cristallographique (11-20) de la couche c-SiC, à mieux que 0,1°.

Même si cette problématique d'alignement vient d'être décrite en référence aux composants élaborés sur une couche mince en SiC, elle se retrouve potentiellement avec des couches minces monocristallines composées d'autres matériaux.

Il est donc avantageux de fournir une structure composite sur laquelle il est possible de retrouver, de manière reproductible, au moins un axe cristallographique de la couche mince, de manière à créer des marques d'alignement cohérentes avec ledit axe et utilisables à tous les niveaux de masques nécessaires, pour l'élaboration des composants verticaux.

Des exemples de procédés connus pour aligner deux substrats avant l'étape de collage des substrats pour obtenir des substrats composites sont décrits dans US2002123204 A1, US2004151917 A1 ou US2018323069 A1.

Le substrat support et le substrat donneur utilisés pour la fabrication de la structure composite présentent habituellement chacun un méplat ou une encoche (appelée « notch » selon la terminologie anglo-saxonne) qui indique un axe cristallographique contenu dans le plan de la face avant du substrat, avec une précision de +/-1°.

Une telle imprécision ne permet pas de se baser sur le méplat ou l'encoche d'un substrat pour définir des marques d'alignement représentatives d'un axe cristallographique de manière reproductible, avec une précision de +/-0,1°.

Ajoutant à cela les imprécisions d'alignement lors de l'assemblage des substrats, pour former la structure composite, il apparaît clairement impossible de se baser sur le méplat ou l'encoche du substrat support pour définir des marques d'alignement représentatives d'un axe cristallographique de la couche mince issue du substrat donneur.

Pour réaliser un repérage précis d'un axe cristallographique, il serait nécessaire d'utiliser des outils de diffractométrie de rayons X (DRX ou XRD selon l'abréviation anglaise de « X Ray diffraction »), ce qui complexifie grandement le procédé de fabrication de la structure composite.

### OBJET DE L'INVENTION

La présente invention vise à remédier à tout ou partie des inconvénients précités. Elle concerne un procédé de fabrication d'une structure composite comprenant une couche mince monocristalline (par exemple en SiC) disposée sur un substrat support, ladite structure composite autorisant un alignement précis sur un axe cristallographique de ladite couche mince.

### BREVE DESCRIPTION DE L'INVENTION

L'invention concerne un procédé de fabrication d'une structure composite comprenant une couche mince en un premier matériau monocristallin disposée sur un substrat support. Le procédé comprend :
- une étape a) de fourniture d'un substrat donneur composé du premier matériau monocristallin présentant une face avant et une face arrière,
- une étape b) de fourniture d'un substrat support présentant une face avant, une face arrière, une tranche et un premier motif d'alignement sur l'une desdites faces ou sur la tranche,
- une étape c) de traitement thermique appliqué au moins au substrat donneur (10), sous atmosphère contrôlée et à une température apte à provoquer une réorganisation de surface sur au moins une des faces dudit substrat, la réorganisation de surface donnant lieu à la formation de premières marches d'amplitude nanométrique, parallèles à un premier axe principal,
- une étape d) d'assemblage du substrat donneur et du substrat support comprenant, avant la mise en contact des substrats, un alignement optique, à mieux que +/-0,1°, entre une marque de repérage indiquant le premier axe principal sur le substrat donneur et au moins un motif d'alignement du substrat support,
- une étape e) de transfert d'une couche mince issue du substrat donneur sur le substrat support.

Selon d'autres caractéristiques avantageuses et non limitatives de l'invention, prises seules ou selon toute combinaison techniquement réalisable :
- le premier motif d'alignement du substrat support est un méplat ou une encoche aménagé(e) au niveau de sa tranche, et l'alignement optique lors de l'étape d'assemblage utilise ledit premier motif d'alignement ;
- le premier matériau est le carbure de silicium et la température du traitement thermique de l'étape c) est supérieure ou égale à 1500°C, préférentiellement supérieure ou égale à 1600°C ;
- le substrat support est en carbure de silicium monocristallin, et l'étape de traitement thermique est appliquée également au substrat support et provoque une réorganisation de surface sur au moins une des faces dudit substrat, la réorganisation de surface donnant lieu à la formation de deuxièmes marches d'amplitude nanométrique, parallèles à un deuxième axe principal ;
- un deuxième motif d'alignement sur le substrat support est formé par les deuxièmes marches elles-mêmes, par au moins un motif défini par photolithographie et gravure sur la face avant du substrat support à partir des deuxièmes marches, ou par au moins un motif défini par photolithographie et gravure sur la face arrière du substrat support à partir des deuxièmes marches ;
- l'alignement optique lors de l'étape d'assemblage utilise ledit deuxième motif d'alignement ;
- le premier matériau est l'arséniure de gallium et la température du traitement thermique de l'étape c) est supérieure ou égale à 630°C ;
- le premier matériau est le phosphure d'indium et la température du traitement thermique de l'étape c) est supérieure ou égale à 600°C ;
- la marque de repérage est formée par les premières marches elles-mêmes, par au moins une marque définie par photolithographie et gravure sur la face avant du substrat donneur à partir des premières marches, ou par au moins une marque définie par photolithographie et gravure sur la face arrière du substrat donneur à partir des premières marches ;
- l'étape d'assemblage comprend un polissage mécano-chimique de la face avant du substrat donneur et/ou de la face avant du substrat support, avant la mise en contact des deux substrats ;
- l'étape d'assemblage comprend le dépôt d'une couche intermédiaire sur la face avant du substrat donneur et/ou sur la face avant du substrat support, préalablement à la mise en contact des deux substrats ;
- le procédé de fabrication comprend, avant l'étape d'assemblage, une étape de formation d'un plan fragile enterré dans le substrat donneur, délimitant la couche mince entre ledit plan fragile enterré et la face avant du substrat donneur ;
- le procédé de fabrication comprend, au cours de l'étape de transfert, une séparation le long du plan fragile enterré pour former la structure composite comprenant la couche mince disposée sur le substrat support d'une part, et le reste du substrat donneur d'autre part.

### BREVE DESCRIPTION DES FIGURES

D'autres caractéristiques et avantages de l'invention ressortiront de la description détaillée de l'invention qui va suivre en référence aux figures annexées sur lesquelles :
- La figure 1 présente une structure composite élaborée selon un procédé de fabrication conforme à l'invention ;
- Les figures 2a à 2e présentent des étapes d'un procédé de fabrication conforme à l'invention.
- Les figures 3, 4, 5, 6a, 6b et 6c présentent des étapes alternatives ou optionnelles du procédé de fabrication conforme à l'invention.

### DESCRIPTION DETAILLEE DE L'INVENTION

Dans la partie descriptive, les mêmes références sur les figures pourront être utilisées pour des éléments de même type. Les figures sont des représentations schématiques qui, dans un objectif de lisibilité, ne sont pas à l'échelle. En particulier, les épaisseurs des couches selon l'axe z ne sont pas à l'échelle par rapport aux dimensions latérales selon les axes x et y ; et les épaisseurs relatives des couches entre elles ne sont pas nécessairement respectées sur les figures.

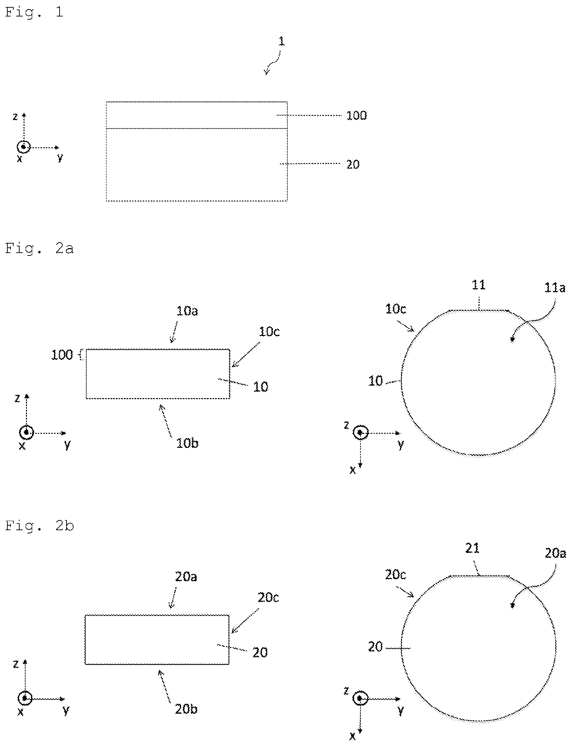

La présente invention concerne un procédé de fabrication d'une structure composite 1 comprenant une couche mince 100 en un premier matériau monocristallin disposée sur un substrat support 20 (figure 1).

Le premier matériau pourra notamment être le carbure de silicium (SiC), l'arséniure de gallium (GaAs), le phosphure d'indium (InP), le nitrure de gallium (GaN), le nitrure d'aluminium (AlN), le silicium germanium (SiGe), le silicium (Si), le germanium (Ge) ou autres. Dans la suite de la description, « c-SiC » ou « c-matériau », en général, sera utilisé pour parler respectivement de carbure de silicium monocristallin ou dudit matériau sous forme monocristalline.

Le procédé comprend en premier lieu une étape a) de fourniture d'un substrat donneur 10 composé du premier matériau monocristallin (figure 2a).

La couche mince 100 de la structure composite 1 sera formée, à l'issue du procédé de la présente invention, à partir du substrat donneur 10 : ainsi, l'orientation cristallographique, la qualité cristalline ainsi que le niveau de dopage du substrat donneur 10 sont choisis pour répondre aux spécifications requises des composants, par exemple verticaux, destinés à être élaborés sur la couche mince 100.

A titre d'exemple, un substrat donneur 10 en c-SiC pourra être de polytype 4H ou 6H, présentant une désorientation ("offcut") inférieure à 4.0° par rapport à l'axe cristallographique <11-20> ± 0.5°, et une densité de dislocations traversantes (« Micropipes ») inférieure ou égale à 5/cm², voire inférieure à 1/cm². Dopé de type N (azote), il présente une résistivité préférentiellement comprise entre 0.015 ohm.cm et 0.030 ohm.cm. On pourra choisir un substrat donneur 10 présentant une faible densité de dislocation de plan basal (BPD pour « basal plane dislocation » selon la terminologie anglo-saxonne), typiquement inférieure ou égale à 1500/cm² selon la sensibilité des composants visés à ces défauts.

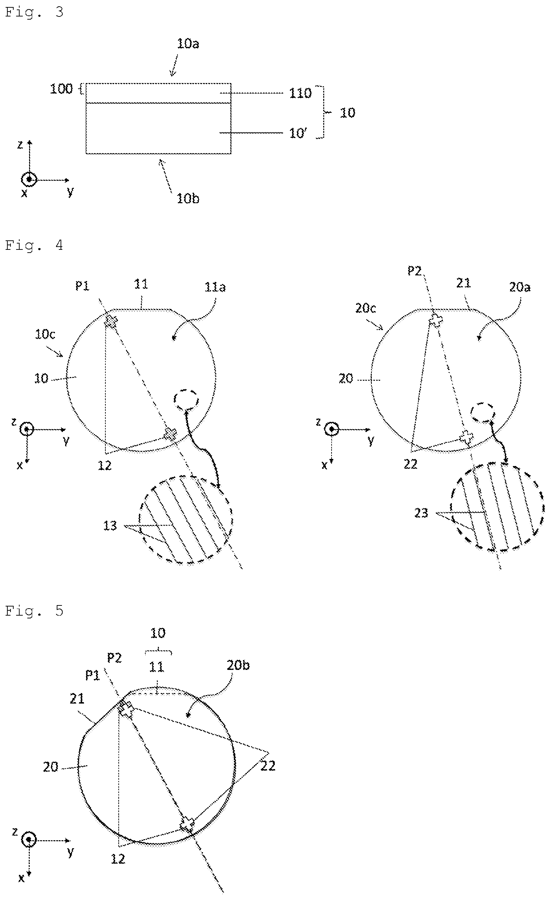

Alternativement, le substrat donneur 10 en c-SiC peut comporter un substrat initial 10' et une couche superficielle 110 du côté de sa face avant 10a, élaborée par exemple par épitaxie, et présentant les propriétés requises pour la future couche mince 100 ; cette dernière sera formée, à l'issue du procédé de la présente invention, à partir de ladite couche superficielle 110 (figure 3). On pourra viser, dans ce cas, une densité de défauts de type BPD dans la couche superficielle 110 inférieure à celle du substrat initial 10', et avantageusement inférieure à 5/cm², voire inférieure à 1/cm².

Toujours à titre d'exemple, un substrat donneur 10 en c-InP pourra présenter une désorientation ("offcut") de 2°.

Le substrat donneur 10 se présente préférentiellement sous la forme d'une plaquette circulaire de diamètre 100mm ou 150mm voire 200mm et d'épaisseur comprise typiquement entre 300 et 800 microns. Il présente une face avant 10a, une face arrière 10b et une tranche 10c formant son pourtour circulaire. La rugosité de surface de la face avant 10a est avantageusement choisie inférieure à 1 nm Ra, rugosité moyenne (« average roughness ») mesurée par microscopie à force atomique (AFM) sur un scan de 20 microns x 20 microns.

Le substrat donneur 10 comprend habituellement un méplat 11 ou une encoche (appelée « notch » selon la terminologie anglo-saxonne) aménagé(e) au niveau de sa tranche 10c. En général, le méplat 11 (ou l'encoche) repère un axe cristallographique particulier, contenu dans le plan (x,y) de la face avant 10a : pour un substrat en c-SiC, l'axe cristallographique (11-20) est par exemple parallèle au méplat 11. La précision de ce repérage est néanmoins faible, puisque le méplat 11 garantit la direction de l'axe cristallographique à +/-1°.

Selon une autre option, le substrat donneur 10 peut comporter un ou plusieurs motifs micrométriques ou millimétriques réalisés par les techniques connues de lithographie, gravure et dépôt, sur sa face avant 10a ou sur sa face arrière 10b, et susceptibles d'indiquer une direction cristallographique particulière.

Le procédé comprend également une étape b) de fourniture d'un substrat support 20 (figure 2b). Ce dernier peut être choisi en tout matériau compatible avec les procédés microélectroniques habituellement mis en oeuvre pour élaborer des composants à base du premier matériau. Le substrat support 20 pourra donc être en silicium, carbure de silicium, arséniure de gallium, phosphure d'indium, etc.

Avantageusement, lorsque le premier matériau du substrat donneur (10) (et de la couche mince (100)) est le carbure de silicium, le substrat support 20 est en carbure de silicium poly-cristallin (p-SiC) ou en carbure de silicium monocristallin. Dans ce dernier cas, on peut tolérer un niveau de défauts et de dislocations plus élevé que pour le substrat donneur 10 (et la couche mince 100 qui en sera issue). Préférentiellement, le substrat support 20 présente une résistivité comprise entre 0.015 ohm.cm et 0.030 ohm.cm pour répondre aux exigences de conduction électrique des composants verticaux susceptibles d'être élaborés sur la future structure composite 1.

Le substrat support 20 se présente préférentiellement sous la forme d'une plaquette circulaire de diamètre 100mm ou 150mm voire 200mm et d'épaisseur comprise typiquement entre 300 et 800 microns. Il présente une face avant 20a, une face arrière 20b et une tranche 20c formant son pourtour circulaire. La rugosité de surface de la face avant 20a est avantageusement choisie inférieure à 1 nm Ra, comme pour le substrat donneur 10.

Le substrat support 20 comprend en général un motif d'alignement 21 (appelé premier motif d'alignement 21 par la suite), qui est disposé sur l'une des faces avant 20a et arrière 20b ou sur la tranche 20c. Sur la figure 2b, le premier motif d'alignement 21 est un méplat aménagé au niveau de la tranche 20c du substrat support 20. Alternativement, le premier motif d'alignement peut consister en une encoche également aménagée au niveau de la tranche 20c. Selon encore une autre option, le premier motif d'alignement 21 peut consister en un ou plusieurs motifs micrométriques ou millimétriques réalisés par les techniques connues de lithographie, gravure et dépôt, sur la face avant 20a ou sur la face arrière 20b du substrat support 20, et susceptibles d'indiquer une direction particulière ou de servir de repère pour aligner des niveaux de masques lithographiques ultérieurs.

Dans la cas d'un substrat support 20 monocristallin, le premier motif d'alignement 21 repère un axe cristallographique contenu dans le plan (x,y) parallèle à la face avant 20a du substrat 20, comme expliqué précédemment pour le substrat donneur 10, avec une précision de +/-1°.

Le procédé selon l'invention comprend ensuite une étape c) de traitement thermique appliqué au substrat donneur 10 et éventuellement au substrat support 20, sous atmosphère contrôlée et à une température apte à provoquer une réorganisation de surface sur au moins une des faces du substrat traité. La réorganisation de surface donne lieu à la formation de marches (« step bunching » selon la terminologie anglo-saxonne) parallèles entre elles et présentant une amplitude nanométrique, par exemple de l'ordre de quelques nanomètres jusqu'à 500nm.

Sans que cela soit limitatif, quelques exemples de traitements thermiques sont indiqués ci-après, pour différentes natures de premier matériau.

Lorsque le premier matériau est le carbure de silicium, le traitement thermique de l'étape c) est appliquée au substrat donneur 10 (et potentiellement au substrat support 20, si lui aussi est en carbure de silicium) à une température supérieure ou égale à 1500°C, préférentiellement supérieure ou égale à 1600°C,. La température est typiquement choisie entre 1500°C et 1800°C, par exemple 1700°C, et l'atmosphère est avantageusement neutre ou réductrice, à base d'argon et/ou d'un mélange d'argon et d'environ 2% d'hydrogène. Une telle température est suffisamment élevée pour qu'au moins un composé du carbure de silicium (en l'occurrence ici le Silicium) soit apte à exo-diffuser.

Appliqué à un substrat de c-SiC, un tel traitement thermique provoque une réorganisation de surface sur au moins une des faces dudit substrat donnant lieu à la formation de marches parallèles entre elles et présentant une amplitude nanométrique, de l'ordre de quelques nanomètres jusqu'à 500nm.

Lorsque le premier matériau est l'arséniure de gallium, la température du traitement thermique de l'étape c) est choisie supérieure ou égale à 630°C, sous une atmosphère d'arsine ; l'exo-diffusion de l'arsenic provoque la réorganisation de surface attendue.

Lorsque le premier matériau est le phosphure d'indium, la température de traitement thermique de l'étape c) est choisie supérieure ou égale à 600°C, sous une atmosphère de phosphine ; c'est alors le phosphore qui tend à exo-diffuser et la réorganisation de surface sous forme de marches peut s'opérer.

Dans les exemples évoqués et plus généralement quel que soit le premier matériau du substrat donneur 10, l'application du traitement thermique de l'étape c), sous atmosphère contrôlée permet une réorganisation de la surface sous forme de marches et évite (ou limite) l'apparition de trous (« etch pits » selon la terminologie anglo-saxonne).

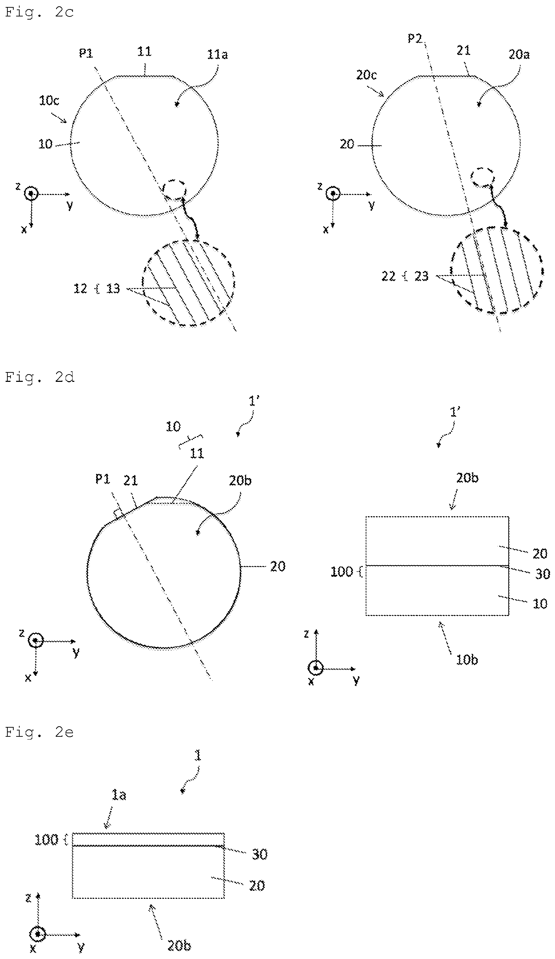

Ainsi, comme illustré sur la figure 2c, après l'étape de traitement thermique, le substrat donneur 10 présente des marches 13 (appelée premières marches par la suite) sur sa face avant 10a et/ou sur sa face arrière 10b, toutes parallèles à un axe principal P1 (appelé premier axe principal) : cet axe principal P1 indique un axe cristallographique bien défini, dépendant de la nature du premier matériau.

En l'occurrence, si le substrat donneur 10 est en c-SiC de polytype 4H ou 6H, l'axe principal P1 est parallèle à l'axe cristallographique (1-100).

La présence des premières marches 13, sur la face avant 10a et/ou sur la face arrière 10b du substrat donneur 10 peut constituer une marque de repérage 12 indiquant l'axe principal P1, et par conséquent l'axe cristallographique associé dans le plan (x,y).

Selon une autre option, la marque de repérage 12 est formée par au moins une marque définie par les techniques conventionnelles de photolithographie et gravure, sur la face avant 10a du substrat donneur 10, à partir des premières marches 13 (figure 4) .

Selon encore une autre option, au moins une marque est définie sur la face arrière 10b du substrat donneur 10 à partir des premières marches 13, formant ainsi la marque de repérage 12 au niveau de la face arrière 10b. Cette option est avantageuse en ce qu'elle évite une structuration locale de la face avant 10a du substrat donneur 10, ce qui est favorable à une étape ultérieure d'assemblage.

Si le substrat support 20 est composé du premier matériau monocristallin, comme le substrat donneur 10, l'étape c) de traitement thermique peut également lui être appliquée : des marches 23 (appelées deuxièmes marches) sont ainsi générées sur sa face avant 20a et/ou sur sa face arrière 20b, toutes parallèles à un axe principal P2 (appelé deuxième axe principal) : cet axe principal P2 indique un axe cristallographique bien défini du substrat support 20.

Notons qu'une étape c) de traitement thermique, différente (en termes de température et/ou atmosphère) de celle appliquée au substrat donneur 10, pourrait être appliquée au substrat support 20, s'il est composé d'un matériau monocristallin différent du premier matériau. Les conditions de l'étape c) seraient alors définies de manière à provoquer la réorganisation de surface recherchée sur le substrat support 20.

Comme illustré sur la figure 2c, la présence des deuxièmes marches 23, sur la face avant 20a et/ou sur la face arrière 20b du substrat support 20 peut constituer un deuxième motif d'alignement 22 indiquant l'axe principal P2, et par conséquent l'axe cristallographique associé dans le plan (x,y).

Selon une autre option, le deuxième motif d'alignement 22 est formé par au moins un motif (défini par les techniques conventionnelles de photolithographie et gravure), sur la face avant 20a du substrat support 20, à partir des deuxièmes marches 23 (figure 4).

Selon encore une autre option, au moins un motif est défini sur la face arrière 20b du substrat support 20 à partir des deuxièmes marches 23, formant ainsi le deuxième motif d'alignement 22 au niveau de la face arrière 20b.

Notons qu'il est possible de privilégier l'apparition des marches 13,23 sur l'une ou l'autre des faces du substrat 10,20 auquel le traitement thermique est appliqué. En particulier, le c-SiC de polytype 4H est polaire et peut présenter, en tant que face avant, une face Si ou une face C : compte tenu des niveaux d'énergie différents de ces deux faces, la reconstruction de surface d'une face Si générera beaucoup plus de marches, d'amplitude plus importante, que la reconstruction d'une face C, dans certaines conditions de recuit.

Le procédé comprend ensuite une étape d) d'assemblage du substrat donneur 10 et du substrat support 20, via leurs faces avant 10a,20a respectives. Cette étape comprend la mise en contact intime des deux substrat 10,20, pour opérer un collage direct, par adhésion moléculaire. Comme cela est bien connu en soi, un tel collage nécessite que les surfaces assemblées soient préalablement nettoyées, pour retirer les contaminations (particulaires, organiques, ...), et potentiellement activées, pour privilégier des terminaisons chimiques de surface favorables à la propagation de l'onde de collage et à la bonne tenue de l'interface de collage.

Selon l'invention, avant la mise en contact des substrats 10,20, un alignement optique, à mieux que +/-0,1°, est effectué entre une marque de repérage 12 indiquant le premier axe principal P1 sur le substrat donneur 10 et au moins un motif d'alignement 21,22 du substrat support 20. L'alignement entre la marque de repérage 12 et le motif d'alignement 21,22 est visé avec une précision meilleure que +/-0,1°, voire meilleure que +/-0,05°. L'objectif de cet alignement est d'assurer que le premier axe principal P1 (correspondant à un axe cristallographique particulier du substrat donneur 10, et donc de la couche mince 100 qui en sera issue) soit précisément repéré par le premier 21 ou le deuxième 22 motif d'alignement du substrat support 20.

Rappelons que l'alignement optique peut être réalisé indifféremment entre des marques ou motifs disposés sur les faces avant 10a,20, les faces arrières 10b,20b ou les tranches 10c,20c des substrats donneur 10 et support 20.

Selon une première variante, l'alignement optique est effectué entre la marque de repérage 12, quelle qu'elle soit, et le premier motif d'alignement 21 du substrat support 20 (figure 2d). Dans un tel cas, il n'est pas nécessaire que le substrat support 20 ait subi l'étape c) de traitement thermique, car un deuxième motif d'alignement 22, basé sur les deuxièmes marches 23 n'est pas utilisé.

La première variante est avantageusement mise en oeuvre lorsque le substrat support 20 comprend un matériau amorphe ou poly-cristallin, par exemple du p-SiC.

Selon une deuxième variante, l'alignement optique est effectué entre la marque de repérage 12, quelle qu'elle soit, et le deuxième motif d'alignement 22 du substrat support 20, quel qu'il soit (figure 5). Dans un tel cas, le traitement thermique de l'étape c) a été appliqué au substrat support 20, de manière à générer les deuxièmes marches 23 requises pour former un deuxième motif d'alignement 22. Cette deuxième variante est avantageusement mise en oeuvre lorsque le substrat support 20 comprend un matériau monocristallin, par exemple du c-SiC. Elle est également préférée dans le cas où la future structure composite 1 est destinée à l'élaboration de composants verticaux. En effet, pour ces composants, il est avantageux d'assembler directement les surfaces semi-conductrices (par exemple en c-SiC) de chacun des substrats 10,20 (par exemple via un collage direct hydrophobe) ; on note cependant qu'un désalignement de plus de 0,2° entre les axes cristallographiques contenus dans le plan (x,y) du substrat donneur 10 et les axes cristallographiques contenus dans le plan (x,y) du substrat support 20 augmente la résistivité de l'interface d'assemblage, ce qui n'est pas favorable à la conduction électrique verticale des composants. Il est donc avantageux de pouvoir aligner les axes cristallographiques des deux substrats 10,20 à +/-0,1° lors de l'assemblage, comme le prévoit le procédé selon l'invention.

L'étape d) d'assemblage des substrats 10,20 peut comprendre un traitement de surface pour lisser l'une ou l'autre des faces avant 10a,20a des substrats donneur 10 et support 20, préalablement à leur mise en contact. En effet, la présence de marches 13 sur au moins la face avant 10a du substrat donneur 10 peut affecter la qualité du collage direct. Les principes évoqués ci-après en référence au substrat donneur 10 s'appliquent de manière similaire lorsque des deuxièmes marches 23 sont présentes sur la face avant du substrat support 20.

Ainsi, un polissage mécano-chimique de la face avant 10a du substrat donneur 10 peut par exemple être opéré avant l'alignement optique et la mise en contact des deux substrats 10,20. Le polissage ayant pour conséquence de faire disparaître les premières marches 13, il est nécessaire qu'une marque de repérage 12 sur le substrat donneur 10 (ou un deuxième motif d'alignement 22 sur le substrat support 20) ait été réalisée à partir des marches 13 avant ledit polissage. Alternativement, même si les premières marches 13 sont éliminées sur la face avant 10a, des marches 13 présentes sur la face arrière 10b du substrat donneur 10 peuvent être utilisées pour élaborer une marque de repérage 12 ou directement pour l'alignement optique.

Toujours préalablement à l'alignement optique et à la mise en contact, l'étape d) d'assemblage peut également comprendre le dépôt d'une couche intermédiaire sur la face avant 10a du substrat donneur 10 et/ou sur la face avant 20a du substrat support 20. La couche intermédiaire peut être une couche isolante ou électriquement conductrice, par exemple métallique, selon le type de composant qui sera élaboré sur la structure composite 1 à l'issue du procédé selon l'invention. La couche isolante peut comprendre un matériau choisi parmi l'oxyde de silicium, le nitrure de silicium, etc ; la couche conductrice peut comprendre un matériau choisi parmi le tungstène (W), les siliciures de tungstène (WSi2), le titane (Ti), le nickel (Ni), les carbonitrures de silicium (SiCNx avec x=10% par exemple), etc. La couche intermédiaire peut également être lissée, par exemple par polissage mécano-chimique, pour faciliter le collage direct des substrats 10,20. Les marches 13,23 sur les faces avant 10a,20a des substrats donneur 10 et support 20 sont ainsi encapsulées et ne gênent pas l'assemblage.

Lors de l'étape d) d'assemblage, la mise en contact des substrats 10,20 peut être faite sous atmosphère ambiante ou sous atmosphère contrôlée, par exemple sous gaz neutre et/ou sous vide. Elle peut également être opérée à une température contrôlée, comprise par exemple entre 20°C et 300°C.

Comme cela est bien connu en soi, la mise en contact des substrats 10,20 s'accompagne de la propagation d'une onde de collage, créant une interface de collage 30 et aboutissant à un ensemble collé 1' (figure 2d).

Le procédé de fabrication selon l'invention comprend enfin une étape e) de transfert d'une couche mince 100 issue du substrat donneur 10 sur le substrat support 20 (figure 2e).

Selon un premier mode de réalisation, le transfert de la couche mince 100 est réalisé par amincissement de la face arrière 10b du substrat donneur 10, jusqu'à l'épaisseur souhaitée de la couche mince 100. Un tel amincissement peut par exemple mettre en oeuvre des techniques conventionnelles de rectification mécanique (« grinding » selon la terminologie anglo-saxonne), de gravure chimique humide ou sèche et/ou de polissage mécano-chimique, en alternance avec des séquences de nettoyage. Un (ou plusieurs) traitement(s) thermique(s) peut(vent) être appliqué(s) pour consolider l'interface de collage ou encore pour améliorer la qualité cristalline et/ou de surface de la couche mince 100.

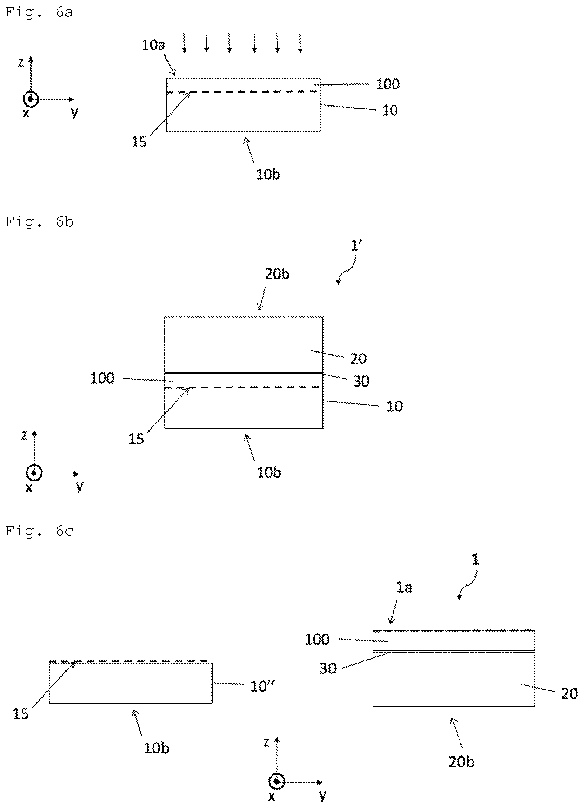

Selon un deuxième mode de réalisation, le transfert de la couche mince 10 est réalisé par le procédé Smart Cut^{™}. Dans ce cas, le procédé de fabrication selon l'invention comprend, avant l'étape d'assemblage, une étape de formation d'un plan fragile enterré 15 dans le substrat donneur 10, délimitant la couche mince 100 entre ledit plan fragile enterré 15 et la face avant 10a du substrat donneur 10 (figure 6a).

De manière avantageuse, une étape d'implantation ionique d'espèces légères est opérée jusqu'à une profondeur déterminée dans le substrat donneur 10. Les espèces légères implantées sont préférentiellement de l'hydrogène, de l'hélium ou une co-implantation de ces deux espèces. Ces espèces légères vont former, autour de la profondeur déterminée, des microcavités distribuées dans une fine couche parallèle à la surface libre du substrat donneur 10, soit parallèle au plan (x,y) sur la figure 6a. On appelle cette fine couche le plan fragile enterré 15, par souci de simplification. L'énergie d'implantation des espèces légères est choisie de manière à atteindre la profondeur déterminée dans le substrat donneur 10, ladite profondeur correspondant à une épaisseur visée de la couche mince 10 après transfert. Par exemple, des ions hydrogène seront implantés à une énergie comprise entre 10 keV et 250 keV (voire jusqu'à 500 keV), et à une dose comprise entre 5^{E}16/cm2 et 1^{E}17/cm2, pour délimiter une couche mince 10 de l'ordre de 100 à 1500 nm. Notons qu'une couche de protection pourra être déposée sur la face avant 10a du substrat donneur 10, préalablement à l'étape d'implantation ionique. Cette couche de protection peut être composée par un matériau tel que l'oxyde de silicium ou le nitrure de silicium.

Toujours dans le deuxième mode de réalisation, l'étape d) d'assemblage précédemment décrite est ensuite effectuée (figure 6b). Puis, l'étape e) de transfert comprend une séparation le long du plan fragile enterré 15, pour former la structure composite 1 comprenant la couche mince 100 disposée sur le substrat support 20 d'une part, et le reste 10'' du substrat donneur d'autre part.

La séparation peut être induite par application d'un traitement thermique à température typiquement comprise entre 200°C et 1000°C, pendant quelques minutes à quelques heures ; en particulier, une température comprise entre 800°C et 1000°C dans le cas d'un premier matériau en c-SiC, ou entre 200°C et 300°C dans le cas d'un premier matériau en c-GaAs, ou encore autour de 300°C dans le cas d'un premier matériau en c-InP. Au cours dudit traitement thermique, les microcavités présentes dans le plan fragile enterré 15 suivent une cinétique de croissance jusqu'à l'initiation spontanée d'une onde de fracture qui va se propager sur toute l'étendue du plan fragile enterré 15 et provoquer la séparation entre la structure composite 1 et le reste 10" du substrat donneur 10.

Alternativement, la séparation peut être induite par application d'une contrainte localisée, ou par une combinaison de traitement thermique et de contrainte mécanique.

Après la séparation, la face libre de la couche mince 10 présente typiquement une rugosité comprise entre 3 et 6 nm Ra (AFM - scan 20 microns x 20 microns). L'objectif pour la fabrication ultérieure de composants est d'avoir une rugosité inférieure à 1 nm Ra.

Ainsi, après l'étape e) de transfert, le procédé de fabrication peut comprendre des étapes de finition appliquées à la structure composite 1. Ces étapes de finition visent en particulier à améliorer la rugosité de la surface libre de la couche mince 100 (face avant 1a de la structure composite 1).

Les étapes de finition peuvent en particulier faire appel à des techniques connues de polissage mécano-chimique, appliquées à la face avant 1a. Elles peuvent également comprendre des traitements thermiques visant à consolider l'interface de collage 30 ou encore à améliorer la qualité cristalline et/ou de surface de la couche mince 100.

Quel que soit le mode de réalisation choisi, à l'issue de l'étape e) de transfert, la marque de repérage 12 du substrat donneur 10 est, soit absente de la structure composite 1 (en particulier si elle était située sur la face arrière 10b du substrat donneur 10), soit peu apparente ou dégradée (si elle était située sur la face avant 10a ou la tranche 10c du substrat donneur 10).

Ainsi, pour élaborer des composants sur ou dans la couche mince 100 en étant aligné sur un axe cristallographique particulier de ladite couche 100, il est possible de se baser sur le motif d'alignement 21,22 du substrat support 20 qui a été utilisé pour l'alignement optique de l'étape d) d'assemblage. Ce motif d'alignement indique avec une grande précision (+/-0,1°) la direction de l'axe cristallographique particulier de la couche mince 100.

### Exemple :

Selon un exemple non limitatif de mise en oeuvre, le substrat donneur 10 fourni à l'étape a) du procédé de fabrication est une plaquette de c-SiC, de polytype 4H, d'orientation 4.0° par rapport à l'axe <11-20> ± 0.5°, de diamètre 150mm et d'épaisseur 350um. La face avant 10a du substrat donneur 10 est une face de type C (carbone), alors que sa face arrière 10b est de type Si (silicium). Le substrat donneur 10 peut comprendre un méplat 11 aménagé au niveau de sa tranche 10c et indiquant à +/-1° près, la direction cristallographique (1-100) contenue dans la plan (x,y) de la face avant 10a dudit substrat 10.

Le substrat support 20 fourni à l'étape b) du procédé de fabrication est une plaquette de c-SiC, de polytype 4H, d'orientation 4.0° par rapport à l'axe <11-20> ± 0.5°, de diamètre 150mm et d'épaisseur 350pm. Le substrat support 20 comprend un méplat 21 aménagé au niveau de sa tranche 20c et indiquant la direction cristallographique (1-100) contenue dans la plan (x,y) de la face avant 20a dudit substrat 20. La face avant 20a est de type Si et la face arrière 20b est de type C.

Une séquence classique de nettoyage est opérée sur les substrats 10,20 préalablement à l'étape c) de traitement thermique.

Le traitement thermique à 1700°C sous argon ou sous argon combiné à 2% d'hydrogène est ensuite appliqué aux deux substrats 10,20, provoquant l'apparition de premières marches 13 sur les faces 10a,10b du substrat donneur 10 et de deuxième marches 23 sur les faces 20a,20b du substrat support 20. Compte tenu des énergies différentes requises par les faces de type Si et les faces de type C pour la réorganisation de surface, les premières marches 13 sur le substrat donneur 10 sont de plus grande amplitude sur sa face arrière 10b (face Si) que sur sa face avant 10a (face C) ; et les deuxièmes marches 23 sur le substrat support 20 sont de plus grande amplitude sur sa face avant 20a (face Si) que sur sa face arrière (face C). Le substrat donneur 10 et le substrat support 20 étant de même nature et de même orientation cristalline, le premier axe principal P1 et le deuxième axe principal P2, respectivement parallèles aux premières marches 13 et aux deuxièmes marches 23 correspondent à un même axe cristallographique (1-100).

A partir des premières marches 13 sur la face arrière 10b du substrat donneur 10, une marque de repérage 12 est définie sur ladite face arrière 10b. A partir des deuxièmes marches 23 sur la face avant 20a du substrat support 20, un deuxième motif d'alignement 22 est défini sur la face arrière 20b dudit substrat 20. Rappelons que la marque 12 et le deuxième motif 22 sont réalisés de manière à indiquer précisément la direction respectivement du premier (P1) et du deuxième (P2) axe principal. Ils peuvent consister chacun en deux croix d'alignement, disposées en bord du substrat associé.

Une implantation d'ions hydrogène est opérée à une énergie de 60keV et une dose de 6^{E}16 H+/cm², à travers la face avant 10a du substrat donneur 10. Optionnellement, le substrat donneur 10 peut comporter une couche de protection au niveau de sa face avant 10a, à travers laquelle les ions sont implantés. Un plan fragile enterré 15 est créé à une profondeur d'environ 500 nm dans le substrat donneur 10.

L'étape d) d'assemblage comprend un polissage mécano-chimique des faces avant 10a,20a des substrats 10,20, pour éliminer les marches 13,23 générées lors de l'étape c) et restaurer un bon état de surface et une rugosité inférieure à 0,2 nm rms, favorable à un assemblage de qualité. Notons que la couche de protection précitée, si elle est présente, sera retirée préalablement au polissage.

Les substrats 10,20 sont ensuite introduits dans un équipement de collage muni d'un module d'alignement autorisant un alignement optique à mieux que +/-0,1°. La marque de repérage 12 en face arrière 10b du substrat donneur 10 et le deuxième motif d'alignement 22 en face arrière 20b du substrat support 20 sont utilisés pour cet alignement optique entre les substrats. Les axes cristallographiques (1-100) des deux substrats 10,20 seront ainsi alignés à mieux que +/- 0,1°. En d'autres termes, après assemblage l'axe cristallographique (1-100) du substrat donneur 10 pourra être décalé par rapport à l'axe cristallographique (1-100) du substrat support 20 de 0,1° au maximum.

L'assemblage s'opère ensuite par la mise en contact des deux substrats, alignés l'un par rapport à l'autre, sous atmosphère neutre (Ar ou N) et sous vide (<1^{E-}8 Pa).

L'étape e) de transfert est réalisée par application d'un recuit à 950°C pendant 30 min : une séparation spontanée le long du plan fragile enterré s'opère, donnant lieu à la structure composite 1 et au reste 10" du substrat donneur.

Le deuxième motif d'alignement 22, présent sur la face arrière 20b du substrat support 20 (qui est également la face arrière de la structure composite 1), indique précisément, à +/-0,1° près (voire mieux), la direction de l'axe cristallographique (1-100) de la couche mince 100 et peut être facilement utilisé lors de l'élaboration de composants sur ladite couche 100 de la structure composite 1.

Bien entendu, l'invention n'est pas limitée aux modes de réalisation et aux exemples décrits, et on peut y apporter des variantes de réalisation sans sortir du cadre de l'invention tel que défini par les revendications.

## Revendications

1. Procédé de fabrication d'une structure composite (1) comprenant une couche mince (100) en un premier matériau monocristallin disposée sur un substrat support (20), le procédé comprenant:
- une étape a) de fourniture d'un substrat donneur (10) composé du premier matériau monocristallin présentant une face avant (10a) et une face arrière (10b),
- une étape b) de fourniture d'un substrat support (20) présentant une face avant (20a), une face arrière (20b), une tranche (20c) et un premier motif d'alignement (21) sur l'une desdites faces ou sur la tranche,
- une étape c) de traitement thermique appliqué au moins au substrat donneur (10), sous atmosphère contrôlée et à une température apte à provoquer une réorganisation de surface sur au moins une des faces (10a,10b) dudit substrat (10), la réorganisation de surface donnant lieu à la formation de premières marches (13) d'amplitude nanométrique, parallèles à un premier axe principal (P1),
- une étape d) d'assemblage du substrat donneur (10) et du substrat support (20) comprenant, avant la mise en contact des substrats (10,20), un alignement optique, à mieux que +/-0,1°, entre une marque de repérage (12) indiquant le premier axe principal (P1) sur le substrat donneur (10) et au moins un motif d'alignement (21,22) du substrat support (20),
- une étape e) de transfert d'une couche mince (100) issue du substrat donneur (10) sur le substrat support (20).

2. Procédé de fabrication selon la revendication précédente, dans lequel :
- le premier motif d'alignement (21) du substrat support (20) est un méplat ou une encoche aménagé(e) au niveau de sa tranche (20c), et
- l'alignement optique lors de l'étape d'assemblage utilise ledit premier motif d'alignement (21).

3. Procédé de fabrication selon l'une des revendications précédentes, dans lequel le premier matériau est le carbure de silicium et dans lequel la température du traitement thermique de l'étape c) est supérieure ou égale à 1500°C, préférentiellement supérieure ou égale à 1600°C.

4. Procédé de fabrication selon la revendication précédente, dans lequel :
- le substrat support (20) est en carbure de silicium monocristallin,
- l'étape de traitement thermique est appliquée également au substrat support (20) et provoque une réorganisation de surface sur au moins une des faces (20a,20b) dudit substrat, la réorganisation de surface donnant lieu à la formation de deuxièmes marches (23) d'amplitude nanométrique, parallèles à un deuxième axe principal (P2),
- un deuxième motif d'alignement (22) sur le substrat support (20) est formé par les deuxièmes marches (23) elles-mêmes, par au moins un motif défini par photolithographie et gravure sur la face avant (20a) du substrat support (20) à partir des deuxièmes marches (23), ou par au moins un motif défini par photolithographie et gravure sur la face arrière (20b) du substrat support (20) à partir des deuxièmes marches (23),
- l'alignement optique lors de l'étape d'assemblage utilise ledit deuxième motif d'alignement (22).

5. Procédé de fabrication selon l'une des revendications 1 et 2, dans lequel le premier matériau est l'arséniure de gallium et dans lequel la température du traitement thermique de l'étape c) est supérieure ou égale à 630°C.

6. Procédé de fabrication selon l'une des revendications 1 et 2, dans lequel le premier matériau est le phosphure d'indium et dans lequel la température du traitement thermique de l'étape c) est supérieure ou égale à 600°C.

7. Procédé de fabrication selon l'une des revendications précédentes, dans lequel la marque de repérage (12) est formée par les premières marches (13) elles-mêmes, par au moins une marque définie par photolithographie et gravure sur la face avant (10a) du substrat donneur (10) à partir des premières marches (13), ou par au moins une marque définie par photolithographie et gravure sur la face arrière (10b) du substrat donneur (10) à partir des premières marches (13).

8. Procédé de fabrication selon l'une des revendications précédentes, dans lequel l'étape d'assemblage comprend un polissage mécano-chimique de la face avant (10a) du substrat donneur (10) et/ou de la face avant (20a) du substrat support (20), avant la mise en contact des deux substrats (10,20).

9. Procédé de fabrication selon l'une des revendications précédentes, dans lequel l'étape d'assemblage comprend le dépôt d'une couche intermédiaire sur la face avant (10a) du substrat donneur (10) et/ou sur la face avant (20a) du substrat support (20), préalablement à la mise en contact des deux substrats (10,20).

10. Procédé de fabrication selon l'une des revendications précédentes, comprenant :
- avant l'étape d'assemblage, une étape de formation d'un plan fragile enterré (15) dans le substrat donneur (10), délimitant la couche mince (100) entre ledit plan fragile enterré (15) et la face avant (10a) du substrat donneur (10),
- au cours de l'étape de transfert, une séparation le long du plan fragile enterré (15) pour former la structure composite (1) comprenant la couche mince (100) disposée sur le substrat support (20) d'une part, et le reste (10") du substrat donneur d'autre part.

## Patentansprüche

1. Verfahren zum Herstellen einer Verbundstruktur (1), umfassend eine dünne Schicht (100) aus einem ersten monokristallinen Material, die auf einem Trägersubstrat (20) angeordnet ist, das Verfahren umfassend:
- einen Schritt a) eines Bereitstellens eines Donorsubstrats (10), das aus dem ersten monokristallinen Material besteht, das eine Vorderseite (10a) und eine Rückseite (10b) aufweist,
- einen Schritt b) des Bereitstellens eines Trägersubstrats (20), das eine Vorderseite (20a), eine Rückseite (20b), einen Rand (20c) und ein erstes Ausrichtungsmuster (21) auf der einen der Seiten oder auf dem Rand aufweist,
- einen Schritt c) eines Wärmebehandelns, das auf mindestens ein Donorsubstrat (10) unter kontrollierter Atmosphäre und bei einer Temperatur angewendet wird, die geeignet ist, um eine Oberflächenneuordnung auf mindestens einer der Seiten (10a, 10b) des Substrats (10) zu bewirken, wobei die Oberflächenneuordnung die Ausbildung von ersten Stufen (13) mit Nanometeramplitude verursacht, die parallel zu einer ersten Hauptachse (P1) sind,
- einen Schritt d) eines Verbindens des Donorsubstrats (10) und des Trägersubstrats (20), umfassend vor dem Inkontaktbringen der Substrate (10, 20) eine optische Ausrichtung besser als +/-01°, zwischen einer Einstellmarke (12), die die erste Hauptachse (P1) auf dem Donorsubstrat (10) angibt, und mindestens einem Ausrichtungsmuster (21,22) des Trägersubstrats (20),
- einen Schritt e) eines Übertragens einer dünnen Schicht (100), die von dem Donorsubstrat (10) stammt, auf das Trägersubstrat (20).

2. Herstellungsverfahren nach dem vorstehenden Anspruch, wobei:
- das erste Ausrichtungsmuster (21) des Trägersubstrats (20) eine Abflachung oder eine Kerbe ist, die an dem Rand (20c) eingerichtet ist, und
- die optische Ausrichtung bei dem Verbindungsschritt das erste Ausrichtungsmuster (21) verwendet.

3. Herstellungsverfahren nach einem der vorstehenden Ansprüche, wobei das erste Material Siliciumcarbid ist und wobei die Temperatur der Wärmebehandlung von dem Schritt c) höher als oder gleich 1500 °C, vorzugsweise höher als oder gleich 1600 °C ist.

4. Herstellungsverfahren nach dem vorstehenden Anspruch, wobei:
- das Trägersubstrat (20) aus monokristallinem Siliciumcarbid ist,
- der Wärmebehandlungsschritt auch auf das Trägersubstrat (20) angewendet wird und eine Oberflächenneuordnung auf mindestens einer der Seiten (20a, 20b) des Substrats bewirkt, wobei die Oberflächenneuordnung die Ausbildung von zweiten Stufen (23) mit Nanometeramplitude verursacht, die parallel zu einer zweiten Hauptachse (P2) sind,
- ein zweites Ausrichtungsmuster (22) auf dem Trägersubstrat (20) durch die zweiten Gänge (23) selbst ausgebildet ist, wobei mindestens ein Muster durch Fotolithographie und Ätzen auf der Vorderseite (20a) des Trägersubstrats (20) aus den zweiten Stufen (23) oder durch mindestens ein Muster, das durch Fotolithographie und Ätzen auf der Rückseite (20b) des Trägersubstrats (20) aus den zweiten Stufen (23) definiert ist,
- die optische Ausrichtung bei dem Verbindungsschritt das zweite Ausrichtungsmuster (22) verwendet.

5. Herstellungsverfahren nach einem der Ansprüche 1 und 2, wobei das erste Material Galliumarsenid ist und wobei die Temperatur der Wärmebehandlung von dem Schritt c) größer als oder gleich 630 °C ist.

6. Herstellungsverfahren nach einem der Ansprüche 1 und 2, wobei das erste Material Indiumphosphid ist und wobei die Temperatur der Wärmebehandlung von Schritt c) größer als oder gleich 600 °C ist.

7. Herstellungsverfahren nach einem der vorstehenden Ansprüche, wobei die Einstellmarke (12) durch die ersten Gänge (13) selbst ausgebildet wird, durch mindestens eine Marke, die durch Fotolithographie und Ätzen auf der Vorderseite (10a) des Donorsubstrats (10) aus den ersten Stufen (13) definiert ist, oder durch mindestens eine Marke, die durch Fotolithographie und Ätzen auf der Rückseite (10b) des Donorsubstrats (10) aus den ersten Stufen (13) definiert ist.

8. Herstellungsverfahren nach einem der vorstehenden Ansprüche, wobei der Verbindungsschritt ein mechanisch-chemisches Polieren der Vorderseite (10a) des Donorsubstrats (10) und/oder der Vorderseite (20a) des Trägersubstrats (20) vor dem Inkontaktbringen der zwei Substrate (10, 20) umfasst.

9. Herstellungsverfahren nach einem der vorstehenden Ansprüche, wobei der Verbindungsschritt das Abscheiden einer Zwischenschicht auf die Vorderseite (10a) des Donorsubstrats (10) und/oder auf die Vorderseite (20a) des Trägersubstrats (20) im Vorfeld des Inkontaktbringens der zwei Substrate (10, 20) umfasst.

10. Herstellungsverfahren nach einem der vorstehenden Ansprüche, umfassend:
- vor dem Verbindungsschritt, einen Schritt des Ausbildens einer eingegrabenen spröden Ebene (15) in dem Donorsubstrat (10), die die dünne Schicht (100) zwischen der eingegrabenen spröden Ebene (15) und der Vorderseite (10a) des Donorsubstrats (10) begrenzt,
- während des Übertragungsschritts, eine Trennung entlang der eingegrabenen spröden Ebene (15) zum Ausbilden der Verbundstruktur (1), umfassend einerseits die dünne Schicht(100), die auf dem Trägersubstrat (20) angeordnet ist, und andererseits den Rest (10") des Donorsubstrats.

## Claims

1. A method for producing a composite structure (1) comprising a thin layer (100) made of a first monocrystalline material arranged on a support substrate (20), the method comprising:
- a step a) of providing a donor substrate (10) which is composed of the first monocrystalline material and has a front face (10a) and a rear face (10b),
- a step b) of providing a support substrate (20) which has a front face (20a), a rear face (20b), an edge (20c) and a first alignment pattern (21) on one of said faces or on the edge,
- a step c) of heat treatment applied at least to the donor substrate (10), under a controlled atmosphere and at a temperature capable of causing a surface reorganization on at least one of the faces (10a,10b) of said substrate (10), the surface reorganization leading to the formation of first steps (13) of nanometric amplitude that are parallel to a first main axis (P1),
- a step d) of joining the donor substrate (10) and the support substrate (20), this step comprising, before bringing the substrates (10,20) into contact, an optical alignment, to better than +/-0.1°, between a locating mark (12) indicating the first main axis (PI) on the donor substrate (10) and at least one alignment pattern (21,22) of the support substrate (20),
- a step e) of transferring a thin layer (100) from the donor substrate (10) onto the support substrate (20).

2. The production method according to the preceding claim, wherein:
- the first alignment pattern (21) of the support substrate (20) is a flat portion or a notch made in its edge (20c), and
- the optical alignment during the joining step uses said first alignment pattern (21).

3. The production method according to either of the preceding claims, wherein the first material is silicon carbide and wherein the temperature of the heat treatment in step c) is greater than or equal to 1500°C, preferably greater than or equal to 1600°C.

4. The production method according to the preceding claim, wherein:
- the support substrate (20) is made of monocrystalline silicon carbide,
- the heat treatment step is also applied to the support substrate (20) and causes a surface reorganization on at least one of the faces (20a, 20b) of said substrate, the surface reorganization leading to the formation of second steps (23) of nanometric amplitude that are parallel to a second main axis (P2),
- a second alignment pattern (22) on the support substrate (20) is formed by the second steps (23), by at least one pattern defined by photolithography and etching on the front face (20a) of the support substrate (20) starting from the second steps (23), or by at least one pattern defined by photolithography and etching on the rear face (20b) of the support substrate (20) starting from the second steps (23),
- the optical alignment during the joining step uses said second alignment pattern (22).

5. The production method according to either of claims 1 and 2, wherein the first material is gallium arsenide and wherein the temperature of the heat treatment in step c) is greater than or equal to 630°C.

6. The production method according to either of claims 1 and 2, wherein the first material is indium phosphide and wherein the temperature of the heat treatment in step c) is greater than or equal to 600°C.

7. The production method according to any of the preceding claims, wherein the locating mark (12) is formed by the first steps (13), by at least one mark defined by photolithography and etching on the front face (10a) of the donor substrate (10) starting from the first steps (13), or by at least one mark defined by photolithography and etching on the rear face (10b) of the donor substrate (10) starting from the first steps (13).

8. The production method according to any of the preceding claims, wherein the joining step comprises chemical-mechanical polishing of the front face (10a) of the donor substrate (10) and/or the front face (20a) of the support substrate (20), before the two substrates (10,20) are brought into contact.

9. The production method according to any of the preceding claims, wherein the joining step comprises depositing an intermediate layer on the front face (10a) of the donor substrate (10) and/or on the front face (20a) of the support substrate (20), prior to the two substrates (10,20) being brought into contact.

10. The production method according to any of the preceding claims, comprising:
- before the joining step, a step of forming a buried fragile plane (15) in the donor substrate (10), delimiting the thin layer (100) between said buried fragile plane (15) and the front face (10a) of the donor substrate (10),
- during the transfer step, separating along the buried fragile plane (15) in order to form the composite structure (1) comprising the thin layer (100) arranged on the support substrate (20), and the rest (10") of the donor substrate.
